(19) **Europäisches Patentamt / European Patent Office / Office européen des brevets**

(11) **EP 4 668 560 A1**

(12) # EUROPEAN PATENT APPLICATION

(43) Date of publication:
**24.12.2025 Bulletin 2025/52**

(21) Application number: **25183279.6**

(22) Date of filing: **17.06.2025**

(51) International Patent Classification (IPC):
**H02M 1/00** $^{(2006.01)}$    **G01R 19/04** $^{(2006.01)}$
**G01R 19/25** $^{(2006.01)}$    **G11C 27/02** $^{(2006.01)}$
**H02M 3/156** $^{(2006.01)}$

(52) Cooperative Patent Classification (CPC):
**G01R 19/0092; G01R 19/04; G01R 19/2509;
G11C 27/024; H02M 1/0009; H02M 3/156**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **18.06.2024 US 202463661253 P
05.06.2025 US 202519229703**

(71) Applicant: **Vertiv Corporation
Westerville, OH 43082 (US)**

(72) Inventors:
• **BALMA, Luigi
  Bologna (IT)**
• **TILOTTA, Livio A.
  Imola (IT)**

(74) Representative: **Beal, James Michael et al
Kilburn & Strode LLP
Lacon London
84 Theobalds Road
London WC1X 8NL (GB)**

(54) **SAMPLE AND HOLD TECHNIQUE FOR READING CHARGER CURRENT IN DISCONTINUOUS CONDUCTION MODE**

(57)      A current monitoring system may include a sample-and-hold circuit to generate a sample-and-hold signal (S/H signal), where the S/H signal corresponds to a peak value of current in a charging circuit within a switching period of the charging circuit. The system may further include a first analog-to-digital channel (ADC channel) to sample the S/H signal and a second ADC channel configured to sample the current in the charging circuit. The system may then determine an average current of the charging circuit based on the first ADC channel when the charging circuit is operating in a discontinuous conduction mode, and determine the average current of the charging circuit based on the second ADC channel when the charging circuit is operating in a continuous conduction mode.

FIG.1

EP 4 668 560 A1

## EP 4 668 560 A1

**Description**

**CROSS-REFERENCE TO RELATED APPLICATIONS**

The present application claims the benefit of U.S. Provisional Application Serial Number 63/661,253, filed June 18, 2024, and of U.S. Non-Provisional Application Serial Number 19/229,703, filed June 5, 2025.

**TECHNICAL FIELD**

The present disclosure relates generally to current monitoring in battery charging circuitry and, more particularly, to current monitoring of battery charging circuitry when in discontinuous conduction mode.

**BACKGROUND**

In many battery charging devices such as, but not limited to, an uninterruptible power supply (UPS), a battery charging circuit shares a converter with a booster circuit. However, the shape of the current in charging applications and boosting applications may vary substantially. In some cases, such a device may enter a discontinuous conduction mode (DCM) when performing charging. However, it may be difficult or impractical to monitor and/or estimate the current used for battery charging while in DCM. In particular, the current may have a discontinuous shape in which positions of current peaks may not be predictable. There is therefore a need to develop systems and methods to provide current monitoring while in DCM.

**SUMMARY**

In embodiments, the techniques described herein relate to a current monitoring system including a sample-and-hold circuit configured to generate a sample-and-hold signal (S/H signal), where the S/H signal corresponds to a peak value of current in a charging circuit within a switching period of the charging circuit; a first analog-to-digital channel (ADC channel) to sample the S/H signal; a second ADC channel configured to sample the current in the charging circuit; and a controller including one or more processors configured to execute program instructions causing the one or more processors to determine an average current of the charging circuit based on the first ADC channel when the charging circuit is operating in a discontinuous conduction mode; and determine the average current of the charging circuit based on the second ADC channel when the charging circuit is operating in a continuous conduction mode.

In embodiments, the techniques described herein relate to a current monitoring system, where the program instructions are further configured to cause the one or more processors to generate control signals for controlling one or more switches in the charging circuit.

In embodiments, the techniques described herein relate to a current monitoring system, where the charging circuit includes a battery charging circuit.

In embodiments, the techniques described herein relate to a current monitoring system, where the battery charging circuit is integrated within an uninterruptible power supply.

In embodiments, the techniques described herein relate to a current monitoring system, where the sample-and-hold circuit includes one or more capacitors configured to hold charge corresponding to the peak value of the current in the charging circuit within the switching period.

In embodiments, the techniques described herein relate to a current monitoring system, where determining the average current of the charging circuit based on the first ADC channel when the charging circuit is operating in the discontinuous conduction mode includes determining the average current of the charging circuit based on the first ADC channel and one or more additional properties of the current in the charging circuit.

In embodiments, the techniques described herein relate to a current monitoring system, where the one or more additional properties of the current in the charging circuit include at least one of the switching period of the charging circuit, a duty cycle of an on mode of the charging circuit relative to the switching period, or the peak value of the current within the switching period from the S/H signal.

In embodiments, the techniques described herein relate to a current monitoring system, where the charging circuit includes a battery charging circuit, where the one or more additional properties of the current in the charging circuit include at least one of the switching period of the charging circuit, a duty cycle of an on mode of the charging circuit relative to the switching period, the peak value of the current within the switching period from the S/H signal, a voltage of a battery charged by the charging circuit, or an inductance of an inductor in the charging circuit.

In embodiments, the techniques described herein relate to a current monitoring method including generating a sample-and-hold signal (S/H signal) corresponding to a peak value of current in a charging circuit within a switching period of the charging circuit; sampling the S/H signal with a first analog-to-digital channel (ADC channel); sampling the current in the charging circuit with a second ADC channel; determining an average current of the charging circuit based on the first ADC channel when the charging circuit is operating in a discontinuous conduction mode; and determining the average current of the charging circuit based on the second ADC channel when the charging circuit is operating in a continuous conduction mode.

In embodiments, the techniques described herein relate to a current monitoring method, further including generating control signals for controlling one or more switches in the charging circuit.

In embodiments, the techniques described herein relate to a current monitoring method, where the charging circuit includes a battery charging circuit.

In embodiments, the techniques described herein relate to a current monitoring method, where the battery charging circuit is integrated within an uninterruptible power supply.

In embodiments, the techniques described herein relate to a current monitoring method, where the sample-and-hold circuit includes one or more capacitors configured to hold charge corresponding to the peak value of the current in the charging circuit within the switching period.

In embodiments, the techniques described herein relate to a current monitoring method, where determining the average current of the charging circuit based on the first ADC channel when the charging circuit is operating in the discontinuous conduction mode includes determining the average current of the charging circuit based on the first ADC channel and one or more additional properties of the current in the charging circuit.

In embodiments, the techniques described herein relate to a current monitoring method, where the one or more additional properties of the current in the charging circuit include at least one of the switching period of the charging circuit, a duty cycle of an on mode of the charging circuit relative to the switching period, or the peak value of the current within the switching period from the S/H signal.

In embodiments, the techniques described herein relate to a current monitoring method, where the charging circuit includes a battery charging circuit, where the one or more additional properties of the current in the charging circuit include at least one of the switching period of the charging circuit, a duty cycle of an on mode of the charging circuit relative to the switching period, the peak value of the current within the switching period from the S/H signal, a voltage of a battery charged by the charging circuit, or an inductance of an inductor in the charging circuit.

In embodiments, the techniques described herein relate to an uninterruptible power supply including a battery charging circuit to charge a battery; a sample-and-hold circuit configured to generate a sample-and-hold signal (S/H signal), where the S/H signal corresponds to a peak value of current in the charging circuit within a switching period of the charging circuit; a first analog-to-digital channel (ADC channel) to sample the S/H signal; a second ADC channel configured to sample the current in the charging circuit; and a controller including one or more processors configured to execute program instructions causing the one or more processors to determine an average current of the charging circuit based on the first ADC channel when the charging circuit is operating in a discontinuous conduction mode; and determine the average current of the charging circuit based on the second ADC channel when the charging circuit is operating in a continuous conduction mode.

In embodiments, the techniques described herein relate to an uninterruptible power supply, where the program instructions are further configured to cause the one or more processors to generate control signals for controlling one or more switches in the charging circuit.

In embodiments, the techniques described herein relate to an uninterruptible power supply, where determining the average current of the charging circuit based on the first ADC channel when the charging circuit is operating in the discontinuous conduction mode includes determining the average current of the charging circuit based on the first ADC channel and one or more additional properties of the current in the charging circuit.

In embodiments, the techniques described herein relate to an uninterruptible power supply, where the one or more additional properties of the current in the charging circuit include at least one of the switching period of the charging circuit, a duty cycle of an on mode of the charging circuit relative to the switching period, the peak value of the current within the switching period from the S/H signal, a voltage of a battery charged by the charging circuit, or an inductance of an inductor in the charging circuit.

It is to be understood that both the foregoing general description and the following detailed description are exemplary and explanatory only and are not necessarily restrictive of the invention as claimed. The accompanying drawings, which are incorporated in and constitute a part of the specification, illustrate embodiments of the invention and together with the general description, serve to explain the principles of the invention.

## BRIEF DESCRIPTION OF DRAWINGS

The numerous advantages of the disclosure may be better understood by those skilled in the art by reference to the accompanying figures.

FIG. 1 illustrates a block diagram view of a current monitoring system, in accordance with one or more embodiments of the present disclosure.

FIG. 2 illustrates a simplified schematic view of a charging circuit, in accordance with one or more embodiments of the present disclosure.

FIG. 3 illustrates challenges associated with determining an average current of a charging circuit in DCM, in accordance with one or more embodiments of the present disclosure.

FIG. 4 illustrates a current waveform associated with DCM operation and a S/H signal generated by a S/H circuit, in accordance with one or more embodiments of the present disclosure.

FIG. 5 illustrates various parameters of a current waveform, in accordance with one or more embodiments of the present disclosure.

FIG. 6 illustrates a plot of average current as a function of and for selected conditions, in accordance with one or more embodiments of the present disclosure.

FIG. 7 illustrates a weight as a function of duty cycle, in accordance with one or more embodiments of the present disclosure.

FIG. 8 is a flow diagram illustrating steps performed in a method for monitoring current in a charging circuit, in accordance with one or more embodiments of the present disclosure.

## DETAILED DESCRIPTION

Reference will now be made in detail to the subject matter disclosed, which is illustrated in the accompanying drawings. The present disclosure has been particularly shown and described with respect to certain embodiments and specific features thereof. The embodiments set forth herein are taken to be illustrative rather than limiting. It should be readily apparent to those of ordinary skill in the art that various changes and modifications in form and detail may be made without departing from the spirit and scope of the disclosure.

Embodiments of the present disclosure are directed to systems and methods providing current monitoring for a charging circuit (e.g., a battery charging circuit) operating in a discontinuous conduction mode (DCM). In many applications, current monitoring (e.g., monitoring of average current, or the like) is used in a control loop to drive one or more switches in the charging circuit. In DCM, the current within an inductor of a charging circuit reaches zero within a switching period, which may occur in the presence of a relatively light load (e.g., when approaching an end of charge voltage in a battery charging application). In this mode, typical techniques for monitoring average current may be impractical or ineffective. For example, sampling the current in DCM may fail to capture the current waveform and may oversample zero-current times.

In embodiments, a current monitoring system implements a sample-and-hold (S/H) technique in which a sample-and-hold signal (S/H signal) is generated that maintains a peak current of a particular current pulse between current pulses. Such a signal may be easily sampled to provide this peak current for each current pulse. The average current may then be determined based on additional information about the current waveform such as, but not limited to, the duty cycle, a period (or frequency) of current pulses, an inductance in the charging circuit, or a peak current. Further, in battery charging applications, the battery voltage may also be used to determine the average current.

For example, a current monitoring system may include a dedicated sample-and-hold circuit (S/H circuit) designed to generate an S/H signal and at least two ADC converter (analog-to-digital converters) channels or ADC converter channels. In this configuration, a first ADC channel may sample the current in the S/H circuit and a second ADC channel may sample the charging circuit directly. When the charging circuit is operating in DCM, the first ADC channel may be used to determine the average current of the charging circuit based on this S/H signal. When the charging circuit is operating in a continuous conduction mode (CCM), the second ADC channel may be used to determine the average current of the charging circuit using traditional techniques.

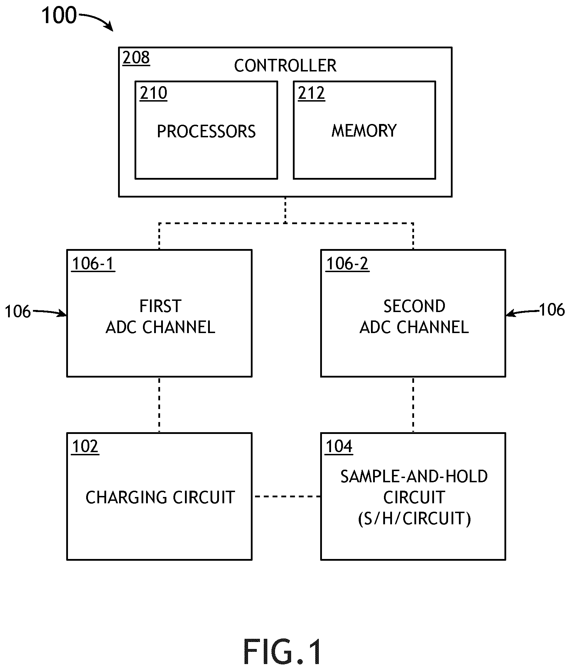

Referring now to FIGS. 1-8, systems and methods providing current monitoring for a charging circuit in DCM using a sample and hold technique are described in greater detail, in accordance with one or more embodiments of the present disclosure.

FIG. 1 illustrates a block diagram view of a current monitoring system 100, in accordance with one or more embodiments of the present disclosure.

A current monitoring system 100 may be configured to monitor and optionally control current in a charging circuit 102 such as, but not limited to, a battery charging circuit. As an illustration, the charging circuit 102 may be integrated within an uninterruptible power supply (UPS).

In some embodiments, the current monitoring system 100 includes a sample-and-hold circuit 104 (e.g., a S/H circuit 104) to generate a sample-and-hold signal (S/H signal), where the S/H signal corresponds to a peak value of the current through the charging circuit 102 within a switching period T.

In some embodiments, the current monitoring system 100 includes one or more ADC channels 106 to capture data associated with a current through a charging circuit 102 and a controller 108 to determine one or more measurements associated with the current through the charging circuit 102 based on the data from the one or more ADC channels 106. The one or more ADC channels 106 may capture any type of data indicative of or related to the current through the charging circuit 102. For example, the one or more ADC channels 106 may capture data indicative of or related to the current from one or more transducers or other sensors.

As an illustration, the current monitoring system 100 may include at least a first ADC channel 106-1 to capture the S/H signal and may optionally include a second ADC channel 106-2 to capture the current through the charging circuit 102 directly.

The controller 108 may generate any number of measurements associated with the current through the charging circuit 102 based on the data captured by the one or more ADC channels 106. For example, the controller 108 may generate measurements of an average value of the current through the charging circuit 102 over a selected timeframe (e.g., a rolling window). As another example, the controller 108 may generate drive signals for the one or more switches 202 in the charging circuit 102 to control the operation of the charging circuit 102. In this way, the controller 108 may implement a charging control algorithm for charging a battery at least in part based on the measurements associated with the current through the charging circuit 102.

In some embodiments, the controller 108 includes one or more processors 110. For example, the one or more processors 110 may be configured to execute a set of program instructions maintained in a memory 112, or memory device. The one or more processors 110 of a controller 108 may include any processing element known in the art. In this sense, the one or more processors 110 may include any microprocessor-type device configured to execute algorithms and/or instructions. For example, the one or more processors 110 may include, but are not limited to, one or more central processing units (CPUs), one or more graphical processing units (GPUs), one or more microprocessors, one or more digital signal processors (DSPs), one or more field-programmable gate array (FPGA) devices, or one or more application-specific integrated circuits (ASICs).

Further, the memory 112 may include any storage medium known in the art suitable for storing program instructions executable by the associated one or more processors 110. For example, the memory 112 may include a non-transitory memory medium. As an additional example, the memory 112 may include, but is not limited to, a read-only memory, a random-access memory, a magnetic or optical memory device (e.g., disk), a magnetic tape, a solid-state drive and the like. It is further noted that memory 112 may be housed in a common controller housing with the one or more processors 110 or different housings.

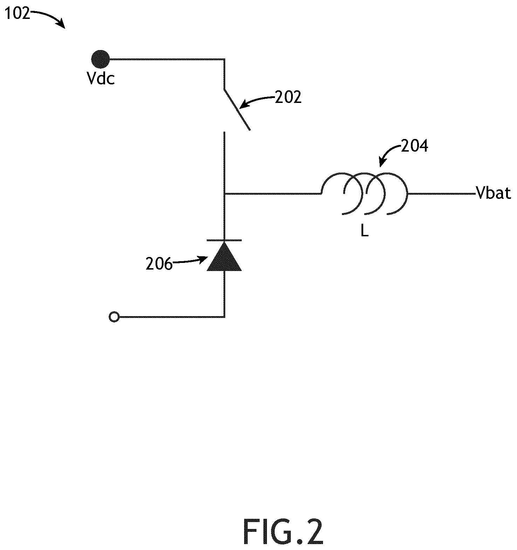

FIG. 2 illustrates a simplified schematic view of a charging circuit 102, in accordance with one or more embodiments of the present disclosure.

In some embodiments, a charging circuit 102 includes one or more switches 202 that control the operation of the charging circuit 102. The one or more switches 202 may be of any type known in the art such as, but not limited to, one or more insulated-gate bipolar transistors.

For example, FIG. 2 depicts a configuration in which the charging circuit 102 includes a switch 202 and an inductor 204 between a charging voltage source ($V_{dc}$) and a battery terminal ($V_{bat}$). In this configuration, the switch 202 controls whether the battery (e.g., $V_{bat}$) is connected to the charging voltage source ($V_{dc}$). Further, the configuration in FIG. 2 includes a diode 206 to control current flow. It is to be understood, however, that FIG. 2 is provided solely for illustrative purposes and should not be interpreted as limiting the scope of the present disclosure. Rather, the charging circuit 102 may have any number or type of components suitable for charging a battery.

The one or more switches 202 in the charging circuit 102 may be driven by drive signals that control the state of the one or more switches. As an illustration, one or more switches in a charging circuit 102 may be driven by pulse-width-modulation (PWM) drive signals using a PWM control technique. In this configuration, a control signal may include a periodic signal with a switching period (e.g., a switching frequency), where a duty cycle is varied. For example, the duty cycle may define a percentage of the switching period associated with an "on" mode in which an inductor (e.g., inductor 204) is charged. The derive signals may be generated using any component such as, but not limited to, the controller 108.

Data associated with the current through a charging circuit 102 may be used for a variety of purposes such as, but not limited to, implementing a charge control algorithm suitable for driving the one or more switches 202. For example, a charge control algorithm may utilize the average current as feedback.

A charging circuit 102 may generally operate in either a continuous conduction mode (CCM) or a discontinuous conduction mode (DCM). In CCM, a current through the charging circuit 102 (e.g., a current through inductor 204 in FIG. 2) is always greater than zero. In DCM, the current through the charging circuit 102 may drop to zero during a switching period. The DCM mode may be triggered by any circumstance, but may commonly occur when the charging circuit 102 is approaching an end of charge voltage (e.g., when a battery being charged is nearing capacity).

Notably, various aspects of a current waveform in DCM such as, but not limited to, a shape, a peak current, or a timing of a peak current may be unpredictable. As a result, it is contemplated herein that monitoring the average current of a charging circuit 102 may be difficult and/or impractical to monitor when in DCM.

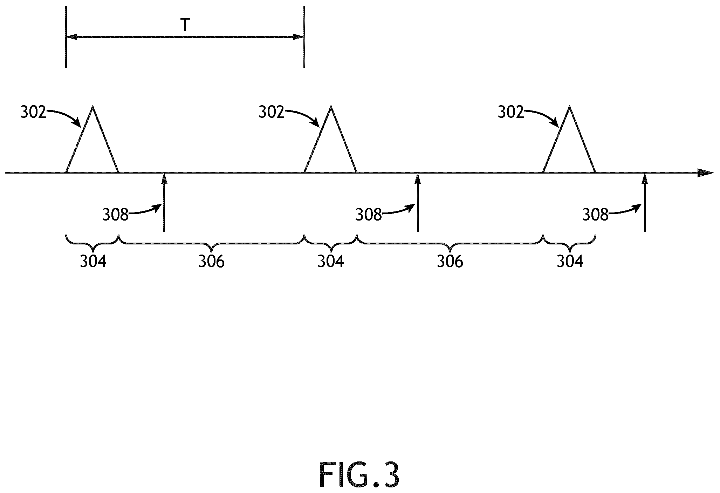

FIG. 3 illustrates challenges associated with determining an average current of a charging circuit 102 in DCM, in accordance with one or more embodiments of the present disclosure. In particular, FIG. 3 depicts a current waveform 302 characterized by positive-current regions 304 and zero-current regions 306, where beginnings of the positive-current regions 304 are separated by a switching period T. FIG. 3 further depicts periodic sampling times 308 for sampling the current waveform 302 (e.g., with the second ADC channel 106-2). In this example, the sampling times 308 fall within the zero-current regions 306, which would result in an erroneous average current measurement of zero. Further, even if the sampling times 308 corresponded to positive-current regions 304, a measurement of average current would not accurately reflect a true average current.

Accordingly, in some embodiments, the current monitoring system 100 may utilize the S/H circuit 104) to generate a sample-and-hold signal (S/H signal), where the S/H signal corresponds to a peak value of the current through the charging circuit 102 within a switching period T.

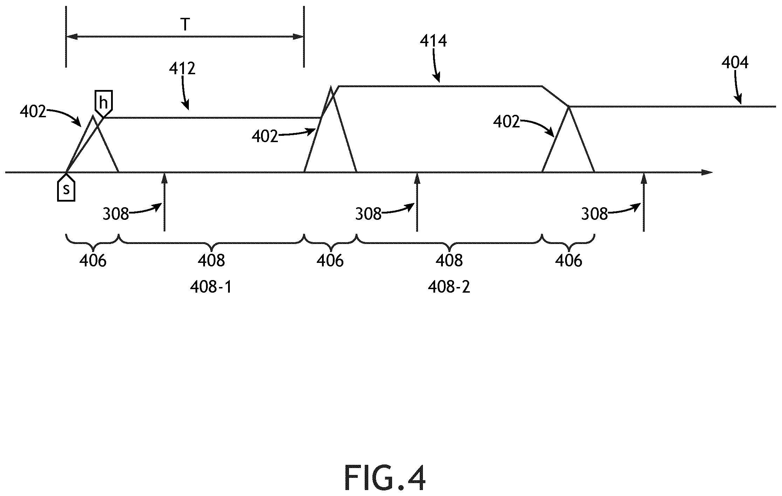

As an illustration, FIG. 4 illustrates a current waveform 402 associated with DCM operation and a S/H signal 404 generated by a S/H circuit 104, in accordance with one or more embodiments of the present disclosure. In FIG. 4, the current waveform 402 includes positive-current regions 406 and zero-current regions 408 as well as sampling times 410 that fall in the zero-current regions 408 in a manner similar to FIG. 3. However, the positive-current regions 406 of the current waveform 402 in FIG. 4 have different properties (e.g., peak values and/or peak times).

However, the S/H signal 404 maintains the peak voltage associated with each of the positive-current regions 406 until a subsequent positive-current region 406. For example, a first peak current 412 associated with a first positive-current region 406-1 is held over a first zero-current region 408-1, a second peak current 414 associated with a second positive-current region 406-2 is held over a second zero-current region 408-2, and so on. In this configuration, values of the current waveform 402 sampled during the sampling times 410 may correspond to peak values within associated switching periods T.

The S/H circuit 104 may include any number or type of components suitable for providing a S/H signal 404 that includes the peak current within each switching period T. For example, the S/H circuit 104 may include at least a capacitor to store charge associated with peak current. Further, the S/H circuit 104 may include additional components such as, but not limited to, additional switches or operational amplifiers.

In some embodiments, the S/H circuit 404 is tied to a drive signal for the one or more switches 202 of the charging circuit 102 (e.g., a PWM drive signal). For example, when the drive signal is associated with an "on" mode, the S/H signal 404 may follow (or correspond to) the current through the charging circuit 102. Otherwise, the S/H signal 404 may hold the current value (e.g., the peak current) until the next "on" mode.

The S/H signal 404 may take any form provided that it maintains a peak value of the positive-current regions 406. For example, the S/H signal 404 may precisely track any positive rises of the current-waveform 402 in positive regions 406. As another example, as shown in FIG. 4, the S/H signal 404 may slightly lag the current waveform 402 during positive rises of the current-waveform 402 in positive regions 406 and hold during a zero-current region 408 until a subsequent positive-current region 406. Further, the S/H signal 404 may provide controlled transitions from a zero-current region 408 to positive region 406.

Measurements of average current through the charging circuit 102 (e.g., through an inductor 204 in FIG. 2) in CCM and DCM is now described in greater detail, in accordance with one or more embodiments of the present disclosure. A measurement of an average current through the charging circuit 102 may be generated using any suitable technique.

In some embodiments, the average current may be determined based on measurements of the current from the second ADC channel 106-2, if present, when the charging circuit 102 is operating in CCM.

In some embodiments, when the charging circuit 102 is operating in DCM, the average current may be determined based on measurements of the S/H signal 404 from the first ADC channel 106-1. Further, any suitable technique may be used to generate a measurement of average current based on measurements of the S/H signal 404 from the first ADC channel 106-1.

For example, the average current ($I_{avg}$) may be calculated as:

$$I_{avg} = \frac{(t_{on}+t_{off}) \cdot i_{PK}}{T \cdot 2} = \frac{Duty \cdot i_{PK}}{2} + \frac{t_{off} \cdot i_{PK}}{T \cdot 2} \tag{1}$$

$$t_{on} = Duty \cdot T \tag{2}$$

where T is a switching period of one or more switches 202 in the charging circuit 102 (e.g., as depicted in FIGS. 3-4), $t_{on}$ is a

time associated with an "on" mode of the charging circuit 102 (e.g., in which the inductor 204 in FIG. 2 is charged), *Duty* is a duty cycle associated with a percentage of $t_{on}$ relative to the switching period $T$, $t_{off}$ is a time associated with positive current after the "on" phase ends, and $i_{PK}$ is a peak current within a switching period T (e.g., a peak current associated with a current pulse).

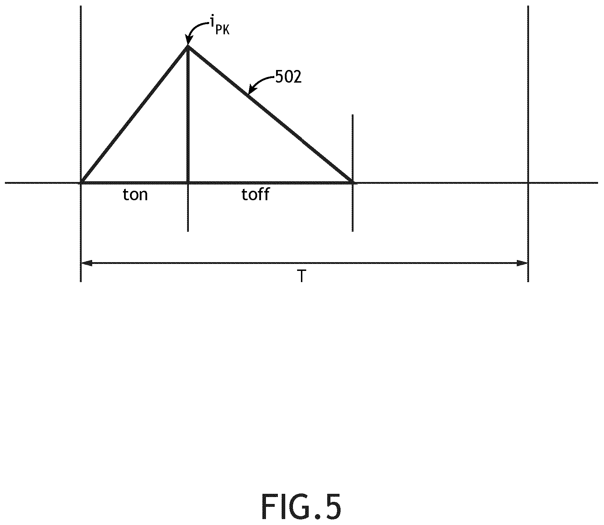

FIG. 5 illustrates various parameters of a current waveform 502, in accordance with one or more embodiments of the present disclosure. In particular, FIG. 5 depicts a relationship between the switching period $T$, the peak current ($i_{PK}$), $t_{on}$ and $t_{off}$ from Equations (1) and (2).

In some applications, it may not be convenient to measure $t_{off}$ directly. However, the value of $t_{off}$ may be related to other parameters that are more readily measurable such as, but not limited to, the battery voltage $V_{bat}$.

As an illustration in the case of the non-limiting design of a charging circuit 102 in FIG. 2, $t_{off}$ may be related to $V_{bat}$ as follows:

$$t_{off} = \frac{i_{PK}}{\frac{di}{dt}} = \frac{i_{PK}}{\frac{V_{bat}}{L}} = \frac{i_{PK} \cdot L}{V_{bat}}. \qquad (3)$$

Putting Equations (1)-(3) together, one can write:

$$I_{avg} = \frac{Duty \cdot i_{PK}}{2} + \frac{L \cdot i_{PK} \cdot i_{PK}}{V_{bat} \cdot T \cdot 2}. \qquad (4)$$

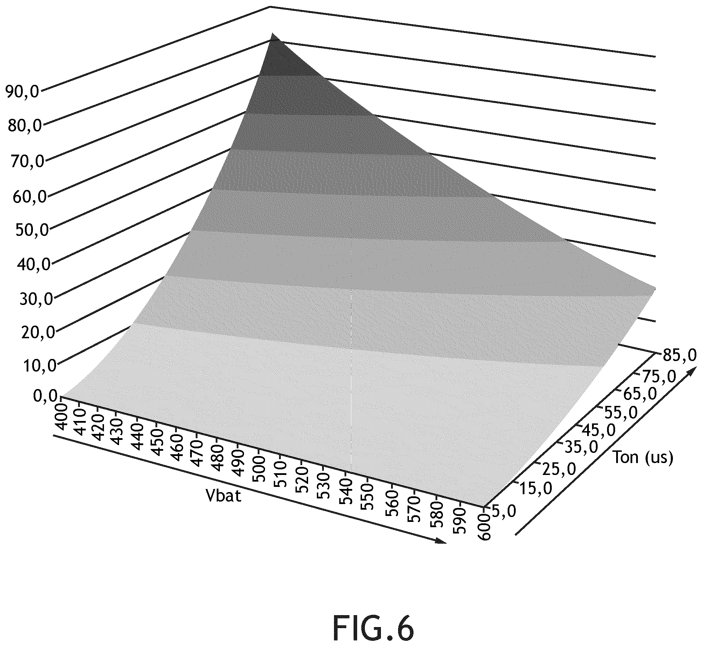

FIG. 6 illustrates a plot of average current as a function of $t_{on}$ and $V_{bat}$ for selected conditions of $L$ and $T$ (e.g., $L$ = 150 $\mu H$ and $T$ = 200 $\mu s$), in accordance with one or more embodiments of the present disclosure.

The Equations (1)-(4) may only be valid in DCM. When the sum of $t_{on}$ and $t_{off}$ exceeds the switching period, the charging circuit 102 is in CCM and the average current may be determined using traditional techniques.

In embodiments in which the average current is measured based on a S/H signal 404 when in DCM (e.g., using a first ADC channel 106-1 as depicted in FIG. 1) and in which the average current is measured based on direct measurements of the current (e.g., using a second ADC channel 106-2 as depicted in FIG. 1), it may be desirable to ensure a smooth a transition when switching between the two measures. Such a smooth transition may be provided by any suitable technique.

In some embodiments, a measurement of an output current is based on a weighted combination of measurement techniques under at least some conditions (e.g., in a transition region).

For example, an output current $I_{charger}$ may be provided as:

$$I_{charg} = G \cdot I_{Direct} + (1 - G) \cdot I_{S/H} \qquad (5)$$

where $I_{Direct}$ is based on a direct measurement of the current (e.g., using a second ADC channel 106-2 as depicted in FIG. 1), $I_{S/H}$ is based on a measurement of the S/H signal 404 (e.g., using a first ADC channel 106-1 as depicted in FIG. 1), and G is a weight.

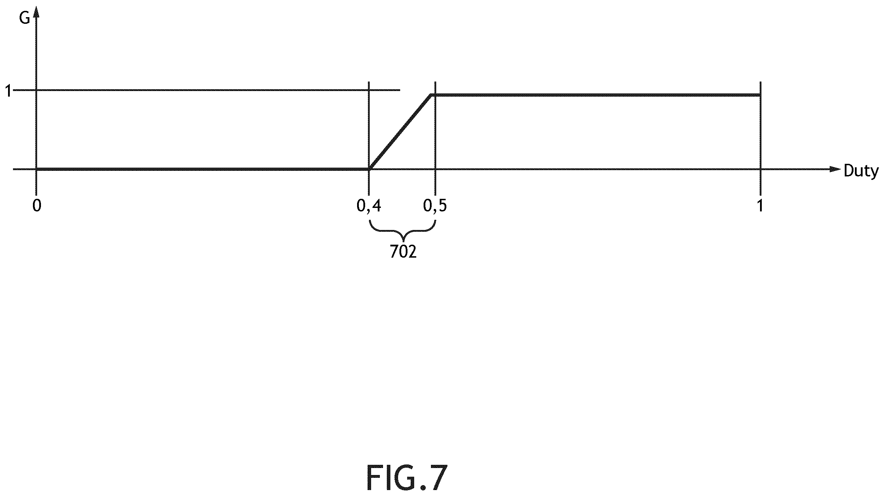

The weight (G) may be a constant or may be a function of another parameter. For example, FIG. 7 illustrates the weight (G) as a function of duty cycle (*Duty*), in accordance with one or more embodiments of the present disclosure. In some cases, the duty cycle may be used to determine when the charging circuit 102 is within DCM or CCM. For example, the CCM may occur when the duty cycle exceeds a certain value (e.g., a ratio of the battery voltage ($V_{bat}$) to the source voltage ($V_{DC}$). In FIG. 7, the weight (G) has a value 0 when the duty cycle is below a transition region 702 (e.g., corresponding to DCM), a value of 1 when the duty cycle is above the transition region 702, and linear between 0 and 1 within the transition region 702 (e.g., corresponding to CCM). In this way, the value of $I_{charger}$ may be determined based on the S/H signal 404 when in DCM, based on the current directly when in CCM, and smoothly transitioned between the two in the transition region.

It is to be understood that FIG. 7 is provided solely for illustrative purposes and should not be interpreted as limiting the scope of the present disclosure. For example, the transition region 702 may have any width. As another example, the transition region 702 may have any monotonic transition between 0 and 1 and need not be linear. As another example, the weight $G$ may be a monotonically varying function across the entire range of duty cycle. As another example, the weight (G) may be a function of another parameter and is not limited to the duty cycle.

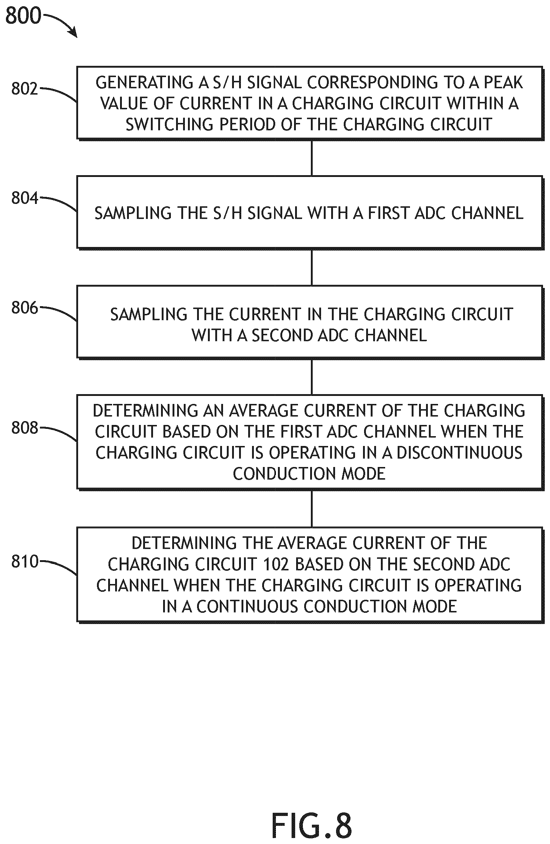

Referring now to FIG. 8, FIG. 8 is a flow diagram illustrating steps performed in a method 800 for monitoring current in a charging circuit, in accordance with one or more embodiments of the present disclosure. The Applicant notes that the embodiments and enabling technologies described previously herein in the context of the current monitoring system 100 should be interpreted to extend to the method 800. For example, the processors 110 in a controller 108 of the current monitoring system 100 may execute program instructions causing the processors 110 to implement any of the steps of the method 800 either directly or indirectly (e.g., by generating control signals for controlling additional components of the current monitoring system 100 and/or external components). Further, although various steps of the method 800 are described herein with respect to the current monitoring system 100, this is merely illustrative and the method 800 is not limited to the architecture of the current monitoring system 100.

In some embodiments, the method 800 includes a step 802 of generating a S/H signal (e.g., the S/H signal 404) corresponding to a peak value of current in a charging circuit 102 within a switching period ($T$) of the charging circuit 102. The S/H signal may be generated using any technique known in the art including, but not limited to, a S/H circuit (e.g., the S/H circuit 104).

In some embodiments, the method 800 includes a step 804 of sampling the S/H signal with a first analog-to-digital channel (ADC channel). The S/H signal may be sampled with any frequency by the first ADC channel. It is contemplated herein that sampling the S/H signal may generate at least one sample corresponding to a peak value of the current of the charging circuit 102 within a switching period.

In some embodiments, the method 800 includes a step 806 of sampling the current in the charging circuit with a second ADC channel. For example, the current in the charging circuit may be captured with a current transducer.

In some embodiments, the method 800 includes a step 808 of determining an average current of the charging circuit based on the first ADC channel when the charging circuit 102 is operating in a discontinuous conduction mode. In some embodiments, the method 800 includes a step 810 of determining the average current of the charging circuit 102 based on the second ADC channel when the charging circuit is operating in a continuous conduction mode. In this way, a measurement of average current of the charging circuit 102 may be generated regardless of the operational mode. In CCM, the average current may be generated based on direct sampling of the current in the charging circuit 102, whereas the average current may be determined based on the S/H signal (and potentially additional parameters of the current waveform that may be known or measured) when in DCM.

Referring now generally to FIGS. 1-8, it is to be understood that references to measurements of the current within a charging circuit 102 are not strictly limiting. Rather, the spirit and scope of the present disclosure extends to measurements of signals that are indicative of or otherwise related to current within the charging circuit 102. For example, the second ADC channel 106-2 may capture and sample a voltage signal that may be indicative of the current or may otherwise have properties that are proportional to the current. Similarly, S/H signal 404 (e.g., sampled by the first ADC channel 106-1) may provide values associated with or proportional to the peak current within a switching period.

The herein described subject matter sometimes illustrates different components contained within, or connected with, other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "connected" or "coupled" to each other to achieve the desired functionality, and any two components capable of being so associated can also be viewed as being "couplable" to each other to achieve the desired functionality. Specific examples of couplable include but are not limited to physically interactable and/or physically interacting components and/or wirelessly interactable and/or wirelessly interacting components and/or logically interactable and/or logically interacting components.

It is believed that the present disclosure and many of its attendant advantages will be understood by the foregoing description, and it will be apparent that various changes may be made in the form, construction, and arrangement of the components without departing from the disclosed subject matter or without sacrificing all of its material advantages. The form described is merely explanatory, and it is the intention of the following claims to encompass and include such changes. Furthermore, it is to be understood that the invention is defined by the appended claims.

The disclosure comprises the following items:

1. A current monitoring system comprising:

a S/H circuit (sample-and-hold circuit) configured to generate a S/H signal, wherein the S/H signal corresponds to a peak value of current in a charging circuit within a switching period of the charging circuit;
a first ADC channel (analog-to-digital channel) to sample the S/H signal;
a second ADC channel configured to sample the current in the charging circuit; and
a controller including one or more processors configured to execute program instructions causing the one or more processors to:

determine an average current of the charging circuit based on the first ADC channel when the charging circuit is operating in a discontinuous conduction mode; and

determine the average current of the charging circuit based on the second ADC channel when the charging circuit is operating in a continuous conduction mode.

2. The current monitoring system of item 1, wherein the program instructions are further configured to cause the one or more processors to:
generate control signals for controlling one or more switches in the charging circuit.

3. The current monitoring system of item 1 or item 2, wherein the charging circuit comprises:
a battery charging circuit.

4. The current monitoring system of any preceding item, wherein the battery charging circuit is integrated within an uninterruptible power supply.

5. The current monitoring system of any preceding item, wherein the sample-and-hold circuit comprises one or more capacitors configured to hold charge corresponding to the peak value of the current in the charging circuit within the switching period.

6. The current monitoring system of any preceding item, wherein determining the average current of the charging circuit based on the first ADC channel when the charging circuit is operating in the discontinuous conduction mode comprises:
determining the average current of the charging circuit based on the first ADC channel and one or more additional properties of the current in the charging circuit.

7. The current monitoring system of any preceding item, wherein the one or more additional properties of the current in the charging circuit comprise:
at least one of the switching period of the charging circuit, a duty cycle of an on mode of the charging circuit relative to the switching period, or the peak value of the current within the switching period from the S/H signal.

8. The current monitoring system of any preceding item, wherein the charging circuit comprises a battery charging circuit, wherein the one or more additional properties of the current in the charging circuit comprise:
at least one of the switching period of the charging circuit, a duty cycle of an on mode of the charging circuit relative to the switching period, the peak value of the current within the switching period from the S/H signal, a voltage of a battery charged by the charging circuit, or an inductance of an inductor in the charging circuit.

9. A current monitoring method comprising:

generating, with a S/H circuit (sample-and-hold circuit), a S/H signal corresponding to a peak value of current in a charging circuit within a switching period of the charging circuit;
sampling the S/H signal with a first ADC channel (analog-to-digital channel);
sampling the current in the charging circuit with a second ADC channel;
determining an average current of the charging circuit based on the first ADC channel when the charging circuit is operating in a discontinuous conduction mode; and
determining the average current of the charging circuit based on the second ADC channel when the charging circuit is operating in a continuous conduction mode.

10. The current monitoring method of item 9, further comprising:
generating control signals for controlling one or more switches in the charging circuit.

11. The current monitoring method of item 9 or item 10, wherein the charging circuit comprises:
a battery charging circuit.

12. The current monitoring method of any of items 9-11, wherein the battery charging circuit is integrated within an uninterruptible power supply.

13. The current monitoring method of any of items 9-12, wherein the sample-and-hold circuit comprises one or more capacitors configured to hold charge corresponding to the peak value of the current in the charging circuit within the switching period.

14. The current monitoring method of any of items 9-13, wherein determining the average current of the charging circuit based on the first ADC channel when the charging circuit is operating in the discontinuous conduction mode comprises:

determining the average current of the charging circuit based on the first ADC channel and one or more additional properties of the current in the charging circuit.

15. The current monitoring method of any of items 9-14, wherein the one or more additional properties of the current in the charging circuit comprise:

at least one of the switching period of the charging circuit, a duty cycle of an on mode of the charging circuit relative to the switching period, or the peak value of the current within the switching period from the S/H signal.

16. The current monitoring method of any of items 9-15, wherein the charging circuit comprises a battery charging circuit, wherein the one or more additional properties of the current in the charging circuit comprise:

at least one of the switching period of the charging circuit, a duty cycle of an on mode of the charging circuit relative to the switching period, the peak value of the current within the switching period from the S/H signal, a voltage of a battery charged by the charging circuit, or an inductance of an inductor in the charging circuit.

17. An uninterruptible power supply comprising:

a charging circuit to charge a battery;
a S/H circuit (sample-and-hold circuit) configured to generate a S/H signal, wherein the S/H signal corresponds to a peak value of current in the charging circuit within a switching period of the charging circuit;
a first ADC channel (analog-to-digital channel) to sample the S/H signal;
a second ADC channel configured to sample the current in the charging circuit; and
a controller including one or more processors configured to execute program instructions causing the one or more processors to:

determine an average current of the charging circuit based on the first ADC channel when the charging circuit is operating in a discontinuous conduction mode; and
determine the average current of the charging circuit based on the second ADC channel when the charging circuit is operating in a continuous conduction mode.

18. The uninterruptible power supply of item 17, wherein the program instructions are further configured to cause the one or more processors to:

generate control signals for controlling one or more switches in the charging circuit.

19. The uninterruptible power supply of item 17 or item 18, wherein determining the average current of the charging circuit based on the first ADC channel when the charging circuit is operating in the discontinuous conduction mode comprises:

determining the average current of the charging circuit based on the first ADC channel and one or more additional properties of the current in the charging circuit.

20. The uninterruptible power supply of any of items 17-19, wherein the one or more additional properties of the current in the charging circuit comprise:

at least one of the switching period of the charging circuit, a duty cycle of an on mode of the charging circuit relative to the switching period, the peak value of the current within the switching period from the S/H signal, a voltage of the battery charged by the charging circuit, or an inductance of an inductor in the charging circuit.

## Claims

1. A current monitoring system comprising:

a sample-and-hold, S/H, circuit configured to generate a S/H signal, wherein the S/H signal corresponds to a peak value of current in a charging circuit within a switching period of the charging circuit;
a first analog-to-digital, ADC, channel configured to sample the S/H signal;
a second ADC channel configured to sample the current in the charging circuit; and
a controller including one or more processors configured to execute program instructions causing the one or more processors to:

determine an average current of the charging circuit based on the first ADC channel when the charging circuit is operating in a discontinuous conduction mode; and
determine the average current of the charging circuit based on the second ADC channel when the charging circuit is operating in a continuous conduction mode.

2. The current monitoring system of claim 1, wherein the program instructions are further configured to cause the one or more processors to:
generate control signals for controlling one or more switches in the charging circuit.

3. The current monitoring system of claim 1 or claim 2, wherein the charging circuit comprises:
a battery charging circuit, and optionally wherein the battery charging circuit is integrated within an uninterruptible power supply.

4. The current monitoring system of any preceding claim, wherein the sample-and-hold circuit comprises one or more capacitors configured to hold charge corresponding to the peak value of the current in the charging circuit within the switching period.

5. The current monitoring system of any preceding claim, wherein determining the average current of the charging circuit based on the first ADC channel when the charging circuit is operating in the discontinuous conduction mode comprises:
determining the average current of the charging circuit based on the first ADC channel and one or more additional properties of the current in the charging circuit.

6. The current monitoring system of claim 5, wherein the one or more additional properties of the current in the charging circuit comprise:
at least one of the switching period of the charging circuit, a duty cycle of an on mode of the charging circuit relative to the switching period, or the peak value of the current within the switching period from the S/H signal.

7. The current monitoring system of claim 5, wherein the charging circuit comprises a battery charging circuit, wherein the one or more additional properties of the current in the charging circuit comprise:
at least one of the switching period of the charging circuit, a duty cycle of an on mode of the charging circuit relative to the switching period, the peak value of the current within the switching period from the S/H signal, a voltage of a battery charged by the charging circuit, or an inductance of an inductor in the charging circuit.

8. A current monitoring method comprising:

generating, with a sample-and-hold, S/H, circuit, a S/H signal corresponding to a peak value of current in a charging circuit within a switching period of the charging circuit;
sampling the S/H signal with a first analog-to-digital, ADC, channel;
sampling the current in the charging circuit with a second ADC channel;
determining an average current of the charging circuit based on the first ADC channel when the charging circuit is operating in a discontinuous conduction mode; and
determining the average current of the charging circuit based on the second ADC channel when the charging circuit is operating in a continuous conduction mode.

9. The current monitoring method of claim 8, further comprising:
generating control signals for controlling one or more switches in the charging circuit.

10. The current monitoring method of claim 8 or claim 9, wherein the charging circuit comprises:
a battery charging circuit, and optionally wherein the battery charging circuit is integrated within an uninterruptible power supply.

11. The current monitoring method of any of claims 8-10, wherein the sample-and-hold circuit comprises one or more capacitors configured to hold charge corresponding to the peak value of the current in the charging circuit within the switching period.

**12.** The current monitoring method of any of claims claim 8-11, wherein determining the average current of the charging circuit based on the first ADC channel when the charging circuit is operating in the discontinuous conduction mode comprises:

determining the average current of the charging circuit based on the first ADC channel and one or more additional properties of the current in the charging circuit.

**13.** The current monitoring method of claim 12, wherein the one or more additional properties of the current in the charging circuit comprise:

at least one of the switching period of the charging circuit, a duty cycle of an on mode of the charging circuit relative to the switching period, or the peak value of the current within the switching period from the S/H signal.

**14.** The current monitoring method of claim 12, wherein the charging circuit comprises a battery charging circuit, wherein the one or more additional properties of the current in the charging circuit comprise:

at least one of the switching period of the charging circuit, a duty cycle of an on mode of the charging circuit relative to the switching period, the peak value of the current within the switching period from the S/H signal, a voltage of a battery charged by the charging circuit, or an inductance of an inductor in the charging circuit.

**15.** An uninterruptible power supply comprising:

a charging circuit configured to charge a battery; and
the current monitoring system of any of claims 1-7.

FIG.1

FIG.2

FIG.3

FIG.4

FIG.5

FIG.6

FIG.7

EP 4 668 560 A1

800

802 — GENERATING A S/H SIGNAL CORRESPONDING TO A PEAK VALUE OF CURRENT IN A CHARGING CIRCUIT WITHIN A SWITCHING PERIOD OF THE CHARGING CIRCUIT

804 — SAMPLING THE S/H SIGNAL WITH A FIRST ADC CHANNEL

806 — SAMPLING THE CURRENT IN THE CHARGING CIRCUIT WITH A SECOND ADC CHANNEL

808 — DETERMINING AN AVERAGE CURRENT OF THE CHARGING CIRCUIT BASED ON THE FIRST ADC CHANNEL WHEN THE CHARGING CIRCUIT IS OPERATING IN A DISCONTINUOUS CONDUCTION MODE

810 — DETERMINING THE AVERAGE CURRENT OF THE CHARGING CIRCUIT 102 BASED ON THE SECOND ADC CHANNEL WHEN THE CHARGING CIRCUIT IS OPERATING IN A CONTINUOUS CONDUCTION MODE

FIG.8

Europäisches
Patentamt

European
Patent Office

Office européen
des brevets

## EUROPEAN SEARCH REPORT

**Application Number**

**EP 25 18 3279**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2018/083541 A1 (LIANG TSORNG-JUU [TW] ET AL) 22 March 2018 (2018-03-22) * Equations (2) and (4); paragraph [0025]; figure 3 * ----- | 1-15 | INV. H02M1/00 G01R19/04 G01R19/25 G11C27/02 |
| X | JIANG YONGJIE ET AL: "An Average Inductor Current Sensor with Enhanced Accuracy in DCM for Buck Converters", 2018 IEEE 61ST INTERNATIONAL MIDWEST SYMPOSIUM ON CIRCUITS AND SYSTEMS (MWSCAS), IEEE, 5 August 2018 (2018-08-05), pages 595-598, XP033508709, DOI: 10.1109/MWSCAS.2018.8623921 [retrieved on 2019-01-22] * page 2 -labelled 596-, right column, last paragraph, first sentence; page 3 -labelled 597, left column, first paragraph, last sentence; figures 4,8 * ----- | 1-15 | ADD. H02M3/156 |
| A | JP 4 923938 B2 (MEIDENSHA ELECTRIC MFG CO LTD) 25 April 2012 (2012-04-25) * figure 1 * ----- | 1-15 | **TECHNICAL FIELDS SEARCHED (IPC)** H02M G01R G11C |

The present search report has been drawn up for all claims

| Place of search | Date of completion of the search | Examiner |
|---|---|---|
| Munich | 17 October 2025 | Varela Fraile, Pablo |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 18 3279

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2025

| Patent document cited in search report | Publication date | Patent family member(s) | Publication date |
|---|---|---|---|
| US 2018083541 A1 | 22-03-2018 | TW 201815047 A<br>US 2018083541 A1 | 16-04-2018<br>22-03-2018 |
| JP 4923938 B2 | 25-04-2012 | JP 4923938 B2<br>JP 2008104244 A | 25-04-2012<br>01-05-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63661253
- US 22970325